# EUROPÄISCHE PATENTANMELDUNG

(11) **EP 1 248 505 A1**
(43) Veröffentlichungstag der Anmeldung: **09.10.2002**
(21) Anmeldenummer: 01108498.5
(22) Anmeldetag: 04.04.2001
(51) Int. Cl.: H05K 7/14

(54) **Frontplatte mit einem entfernbaren Frontplattenteil zur Erzeugung einer Öffnung**

(71) Anmelder: Siemens Schweiz AG, 8047 Zürich (CH)
(72) Erfinder: Laaba, Rahim, 8048 Zürich (CH)
(74) Vertreter: Berg, Peter

(57) **Zusammenfassung**

Die Erfindung bezieht sich auf eine Frontplatte (2) für ein Gerätegehäuse, in dem mindestens eine Leiterplatte aufgenommen ist, wobei die Leiterplatte mindestens einen Aufnahmeplatz zur optionalen Verbindung mit mindestens einem zusätzlichen Modul aufweist und das mindestens eine zusätzliche Modul durch eine aus einer Anzahl von Öffnungen auswählbaren Öffnung in der Frontplatte an den Aufnahmeplatz führbar ist, wobei die Frontplatte an der Anzahl von Öffnungen jeweils einen dem Öffnungsumfang entsprechenden Spalt (4) aufweist, der an mindestens einer Stelle durch mindestens einen Steg (6) unterbrochen wird.

Die spezielle Konturgebung der Stege (6) ermöglicht das Entfernen der Frontplattenstücke (8) von Hand aus Stahlblech mit relativ grosser Blechstärken durch einfaches Herausdrücken und Abscheren.

## Beschreibung

Die Erfindung bezieht sich auf eine Frontplatte für ein Gerätegehäuse, in dem mindestens eine Leiterplatte aufgenommen ist, wobei die Leiterplatte mindestens einen Aufnahmeplatz zur optionalen Verbindung mit mindestens einem zusätzlichen Modul aufweist.

Für ein Gerät der Telekommunikationstechnik sind zur Befestigung von bestückten Platinen Frontplatten aus Stahlblech mit einer Blechstärke von zwei Millimeter vorgesehen. In diesen Frontplatten sind Öffnungen ausgespart, die es gestatten, je nach Ausführungsvariante des Gerätes, die Basisplatine optional mit zusätzlichen Modulen zu verbinden. Somit können die Basisfunktionen des Gerätes durch zusätzlichen Funktionen erweitert werden. Diese modulare Bauweise ermöglicht durch Bestückung der Basisplatine mit einem oder mehreren Modulen ein für das Kundenbedürfnis angepasstes Gerät zu produzieren.

Bei der Erweiterung der Basisplatine mit nur einem Zusatzmodul wird nur eine Öffnung in der Frontplatte benötigt. Werden drei zusatzmodule benötigt, muss die Frontplatte drei Öffnungen aufweisen.

Es muss somit für jede dieser Kombinationen eine entsprechende Frontplatte angefertigt werden (bei der Bestückung mit nur einem Modul, eine Frontplatte mit einer Öffnung; bei der Bestückung mit zwei Modulen, eine Frontplatte mit zwei Öffnungen usw.). Die Vielfalt der sich damit ergebenden Frontplatten führte zu einer erhöhten Lagerhaltung und zu höheren Einkaufspreisen durch die geringere Stückzahl der einzelnen Varianten.
Der Erfindung liegt daher die Aufgabe zugrunde, die Frontplatte im Hinblick auf die Nachteile vorbekannter Frontplatten konstruktiv zu verbessern.

Zur Lösung dieser Aufgabe sieht es die Erfindung vor, dass das mindestens eine zusätzliche Modul durch eine aus einer Anzahl von Öffnungen auswählbaren Öffnung in der Frontplatte an den Aufnahmeplatz führbar ist, wobei die Frontplatte an der Anzahl von Öffnungen jeweils einen dem Öffnungsumfang entsprechenden Spalt aufweist, der an mindestens einer Stelle durch mindestens einen Steg unterbrochen wird.

Weitere vorteilhafte Ausgestaltungen der Erfindung ergeben sich aus den Merkmalen der Unteransprüche.

Mit der vorgenannten Frontplatte der gattungsgemässen Art lassen sich die folgenden Vorteile erzielen:
i) es wird nur noch eine Frontplatte für die verschiedenen Kombinationen der Basisplatine mit den einzelnen Modulen benötigt; damit ergeben sich:
   - geringere Herstellungskosten bzw. Einkaufspreise aufgrund der höheren Stückzahl
   - Aufwand für Logistik und Materialbewirtschaftung sinkt;
ii) mit Anwendung des Laserschneidverfahren zur Erzeugung des Spaltes ist eine gleichmässige Breite und damit Festigkeit des mindestens einen Steges gewährleistet;
iii)bei späterer Nachrüstung bzw. Erweiterung mit zusätzlichen Modulen kann die entsprechende Öffnung vor Ort einfach erzeugt und die Frontplatte muss nicht ausgetauscht werden; und
iv) durch die Formgebung des Steges bleibt nur ein minimaler Grat zurück; die dadurch entstandene lackfreie Stelle ist in bezug auf Oxydation und optischer Erscheinung unproblematisch.

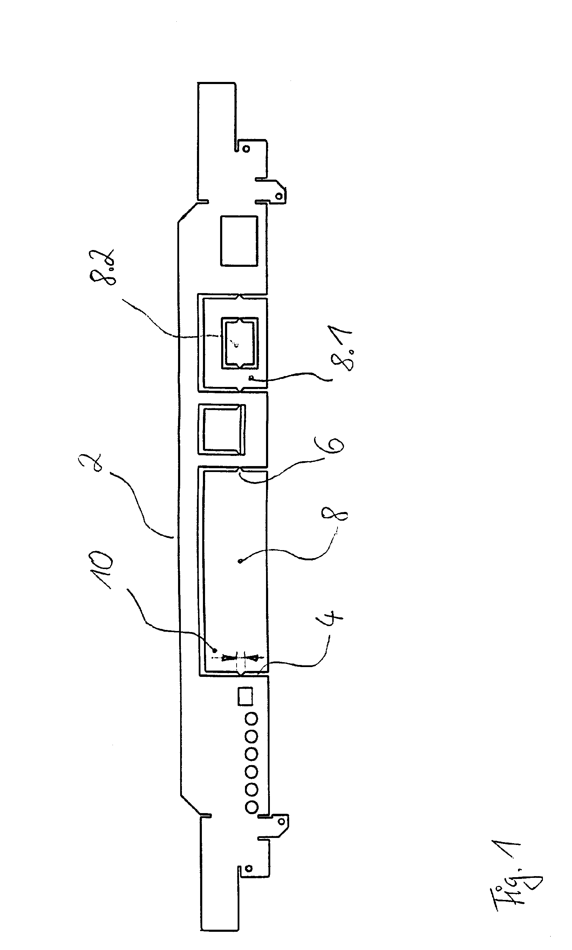

Die Erfindung ist nachfolgend anhand eines in der Zeichnung dargestellten Ausführungsbeispiels einer Frontplatte (2) für ein Gerätegehäuse in der Telekommunikations- und Datentechnik näher erläutert. Das Gerätegehäuse muss dabei nicht rundherum verschlossen sein, sondern kann auch ein Rahmen oder dergleichen mit Frontplatte (2) sein.

Die Frontplatte (2) besteht aus Stahlblech von einer Blechstärke von zwei Millimeter.
Die Frontplattenstücke (8,8.1,8.2), durch dessen Ausbrechen die zum Einsetzen eines zusätzlichen Moduls notwendige Öffnung erzeugt wird, ist an zwei Stellen durch jeweils einen Steg (6) mit der Frontplatte (2) verbunden. Die genaue und regelmässige Kontur wird durch Laserschneiden erzeugt. Dadurch ist eine gleichmässige Festigkeit der Stege (6) gewährleistet. Die Stege (6) mussen eine hinreichende Breite aufweisen, damit das Frontplattenstück (8) nicht zu leicht ausgebrochen werden kann. Andererseits darf die Kraft zum Ausbrechen auch nicht zu hoch sein, will man ein Ausbrechen von Hand noch gewährleisten. Der Querschnitt der Stege (6) verhindert, dass das Frontplattenstück (8) leicht von Hand entfernt werden kann. Eine Entfernung des Frontplattenstückes (8) erfolgt durch Herausdrücken und Abscheren.

Die Stege (6) verlaufen v-förmig oder kegelförmig, wobei die Spitze der V-Form bzw. der Kegelform auf der von dem Frontplattenteil (8) abgewandten Seite angeordnet ist.
Diese spezielle Konturgebung der Stege (6) ermöglicht das Entfernen der Frontplattenstücke (8) von Hand aus Stahlblech mit relativ grosser Blechstärken durch einfaches Abscheren. Die Teile können aber auch maschinell ausgebrochen werden.

Die Stege (6) sind so geformt, dass nach dem Abscheren eine punktförmige Gratstelle zurückbleibt. Die dadurch entstandenen lackfreien Stellen sind optisch sowie in bezug auf eine mögliche Oxydation unproblematisch.

### Liste der verwendeten Bezugszeichen

- 2: Frontplatte
- 4: Spalt
- 6: Steg
- 8: Frontplattenteil
- 8.1: Äusseres Frontplattenteil
- 8.2: Inneres Frontplattenteil
- 10: Breite eines Steges

## Patentansprüche

1. Frontplatte für ein Gerätegehäuse, in dem mindestens eine Leiterplatte aufgenommen ist, wobei die Leiterplatte mindestens einen Aufnahmeplatz zur optionalen Verbindung mit mindestens einem zusätzlichen Modul aufweist
**dadurch gekennzeichnet, dass** das mindestens eine zusätzliche Modul durch eine aus einer Anzahl von Öffnungen auswählbaren Öffnung in der Frontplatte an den Aufnahmeplatz führbar ist, wobei die Frontplatte an der Anzahl von Öffnungen jeweils einen dem Öffnungsumfang entsprechenden Spalt (4) aufweist, der an mindestens einer Stelle durch mindestens einen Steg (6) unterbrochen wird.

2. Frontplatte nach Anspruch 1,
**dadurch gekennzeichnet, dass**
der Spalt (4) regelmässig und konturenscharf ausgebildet ist und ein Frontplattenteil (8) erzeugt, welches über den mindestens einen Steg (6) mit der Frontplatte (2) verbunden ist.

3. Frontplatte nach Anspruch 1 oder 2,
**dadurch gekennzeichnet, dass**
das Frontplattenteil (8.1) erneut an der erforderlichen Öffnung einen dem Öffnungsumfang entsprechenden Spalt (4) aufweist, der an mindestens einer Stelle durch mindestens einen Steg (6) unterbrochen wird und damit ein weiteres Frontplattenteil (8.2) bildet.

4. Frontplatte nach einem der Ansprüche 1 bis 3,
**dadurch gekennzeichnet, dass**
der Spalt (4) durch Laserschneiden erzeugt wird.

5. Frontplatte nach einem der Ansprüche 1 bis 4,
**dadurch gekennzeichnet, dass**
der Steg (6) so ausgestaltet ist, dass das Frontplattenteil (8) gegen zufälliges Ausbrechen gesichert und zugleich die zum Einsetzen eines Moduls erforderliche Entfernbarkeit des Frontplattenteiles (8)gewährleistet ist.

6. Frontplatte nach Anspruch 5,
**dadurch gekennzeichnet, dass**
sich das Frontplattenteil (8) bei Bedarf von Hand herausdrücken und abscheren lässt.

7. Frontplatte nach Anspruch 6,
**dadurch gekennzeichnet, dass**
der Steg (6) so geformt ist, dass nach dem Heraustrennen des Frontplattenteiles (8) eine punktförmige Stelle verbleibt.

8. Frontplatte nach einem der Ansprüche 5 bis 7,
**dadurch gekennzeichnet, dass**
der Steg (6) v-förmig oder kegelförmig verläuft und die Spitze der V-Form bzw. der Kegelform auf der von dem Frontplattenteil (8) abgewandten Seite angeordnet ist.

9. Frontplatte nach einem der vorangegangenen Ansprüche,
**dadurch gekennzeichnet, dass**
die Frontplatte eine Metallplatte ist und vorzugsweise zwischen einem und drei Millimeter dick ist.
